# EUROPÄISCHE PATENTSCHRIFT

(11) **EP 3 062 114 B1**
(45) Veröffentlichungstag und Bekanntmachung des Hinweises auf die Patenterteilung: **29.03.2017**
(21) Anmeldenummer: 16154054.7
(22) Anmeldetag: 03.02.2016
(51) Int. Cl.: G01P 5/24, B06B 3/00, G01F 1/66, H01L 41/09, H01L 41/113, H01L 41/25

(54) **ULTRASCHALLWANDLER UND VERFAHREN ZUR HERSTELLUNG EINES ULTRASCHALLWANDLERS**
ULTRASONIC TRANSDUCER AND METHOD FOR MANUFACTURING AN ULTRASONIC TRANSDUCER
CONVERTISSEUR D'ULTRASONS ET PROCEDE DE FABRICATION D'UN CONVERTISSEUR D'ULTRASONS

(30) Priorität: 26.02.2015 DE 102015102762
(43) Veröffentlichungstag der Anmeldung: 31.08.2016
(73) Patentinhaber: SICK AG, 79183 Waldkirch (DE); Sonotec Ultraschallsensorik Halle GmbH, 06112 Halle / Saale (DE)
(72) Erfinder: Scholder, Jochen, 79183 Waldkirch (DE); Graner, Thomas, 79211 Denzlingen (DE); Romero, Andrés, 79110 Freiburg (DE); Franz, Cornelius Titus, 06114 Halle (DE); zur Horst-Meyer, Santer, 06120 Halle (DE); Münch, Hans-Joachim, 06130 Halle (DE)
(74) Vertreter: Hehl, Ulrich

(56) Entgegenhaltungen:
- EP-A1- 0 945 712
- EP-A1- 1 378 727
- EP-A1- 1 416 255
- EP-A1- 2 602 596
- DE-A1-102004 059 524
- W. KNAPP ET AL: "Influence of Structuring by Laser and Plasma Torch on the Adhesion of Metallic Films on Thermoplastic Substrates", PHYSICS PROCEDIA, Bd. 56, 1. Januar 2014 (2014-01-01), Seiten 791-800, XP055265422, AMSTERDAM, NL ISSN: 1875-3892, DOI: 10.1016/j.phpro.2014.08.087

## Beschreibung

Die Erfindung betrifft eine Ultraschallmessvorrichtung zum Bestimmen einer Strömungsgeschwindigkeit nach dem Oberbegriff von Anspruch 1.

Für die Messung der Strömungsgeschwindigkeit eines Fluids in einer Rohrleitung auf Ultraschallbasis sind unterschiedliche Messprinzipien bekannt. Bei einem Dopplerverfahren wird die je nach Strömungsgeschwindigkeit unterschiedliche Frequenzverschiebung eines an dem strömenden Fluid reflektierten Ultraschallsignals ausgewertet. Bei einem Differenzlaufzeitverfahren wird ein Paar Ultraschallwandler am Außenumfang der Leitung mit einem gegenseitigen Versatz in Längsrichtung montiert, die quer zu der Strömung entlang des zwischen den Ultraschallwandlern aufgespannten Messpfades wechselseitig Ultraschallsignale aussenden und registrieren. Die durch das Fluid transportierten Ultraschallsignale werden je nach Laufrichtung durch die Strömung beschleunigt oder abgebremst. Die resultierende Laufzeitdifferenz wird mit geometrischen Größen zu einer mittleren Strömungsgeschwindigkeit des Fluids verrechnet. Mit der Querschnittsfläche ergibt sich daraus der Volumenstrom oder Durchfluss. Für genauere Messungen können auch mehrere Messpfade mit jeweils einem Paar Ultraschallwandler vorgesehen sein, um einen Strömungsquerschnitt an mehr als einem Punkt zu erfassen.

Herkömmlich werden die Ultraschallwandler meist im Innenraum der Leitung montiert, so dass die Membran direkt in Kontakt mit dem Fluid steht. Die derart eintauchenden Ultraschallwandler sind aber dem Fluid und dessen Druck und Temperatur ausgesetzt und werden dadurch womöglich beschädigt. Umgekehrt können die Ultraschallwandler die Strömung stören und deshalb die Genauigkeit der Messung beeinträchtigen.

In manchen Anwendungen, insbesondere im Hygienebereich, besteht die Anforderung, an der Innenwand der Leitung eine gegenüber dem Fluid möglichst geschlossene Oberfläche zu bieten, damit Ablagerungen vermieden werden und eine vollständige Reinigung möglich ist. Das ist beispielsweise mit der sogenannten Clamp-On-Montage etwa gemäß US 4 467 659 möglich, mit der Ultraschallwandler von außen an der Leitung befestigt werden.

Die EP 1 378 727 B1 schlägt ebenfalls vor, die Ultraschall erzeugenden Elemente an einer Außenseite der Leitungswand anzubringen. Im Gegensatz zur Clamp-On-Technik wird jedoch dabei die Leitungswand selbst als Membran genutzt, die in dem Bereich der Ultraschallwandler eine Tasche mit erheblich geringerer Wandstärke bildet als die restliche Leitungswand. Damit sind die Ultraschallwandler direkt und fest an die Leitungswand angekoppelt, auf deren anderer Seite das Fluid vorbeiströmt. Dadurch ergeben sich eine gute Schallankopplung in das Messmedium und konstruktiv gute Möglichkeiten, ungewollte Körperschalleinkopplungen in den Messbereich in der Leitung zu reduzieren, was sich vorteilhaft auf die erreichbare Messgenauigkeit auswirkt. Diese auch als Clamp-In bezeichnete Montage ist gewissermaßen eine Zwischenform der festen Montage im Innenraum der Leitung und der Clamp-On-Montage.

Die Ultraschallwandler weisen einen Schwingkörper auf, häufig eine Keramik. Mit dessen Hilfe wird beispielsweise auf Basis des piezoelektrischen Effekts ein elektrisches Signal in Ultraschall gewandelt und umgekehrt. Der Schwingkörper ist mit einer schwingungsfähigen Membran gekoppelt, die den Ultraschall abstrahlt oder empfängt. Je nach Anwendung arbeitet der Ultraschallwandler als Schallquelle, Schalldetektor oder beides.

Um aus Schwingkörper und Membran ein gemeinsames schwingfähiges System zu schaffen, ist eine Verbindung erforderlich. Wenn die Membran in Kontakt mit einem Fluid steht, übertragen sich dann auch Belastungen durch Druck und Temperatur des Fluids auf den Schwingkörper. Das kann prinzipiell durch eine Anbindung mit räumlichem Abstand vermieden werden, bei der etwa ein Durchbiegen der Membran den Schwingkörper nicht betrifft. Ein solches mechanisches Konstrukt erfordert aber sehr viel Bauraum, und es ist auch nicht einfach, für eine verlustfreie Ultraschallübertragung zu sorgen. In der DE 20 2013 101 798 U1 wird der Schwingkörper von oben von einer Feder auf die Membran gedrückt. Auch dies erfordert größeren Bauraum und ist mechanisch nicht unempfindlich.

Deshalb wird eher versucht, einen direkten Kontakt zwischen Schwingkörper und Membran zu schaffen, insbesondere durch Verkleben. Die Verbindung muss dann die Druck- und Temperaturschwankungen aushalten.

Es ist an sich bekannt, wenn auch nicht im Zusammenhang mit der Membran eines Ultraschallwandlers, eine zu klebende Oberfläche zuvor aufzurauen. Würde die Membran derart beispielsweise durch Sandstrahlen vorbereitet, so hätte dies aber den gravierenden Nachteil, dass die dabei erzeugte Oberfläche stark vom Prozess und jeweils verwendeten Sand abhängt. Das schränkt die serienmäßige Reproduzierbarkeit ein. Außerdem prägt Sandstrahlen Fremdatome ein, welche die Klebung und möglicherweise auch die akustische Übertragung beeinträchtigen können. Schließlich kann sich ein Blechrohling, aus dem die Membran geschnitten wird, durch das Sandstrahlen verziehen.

Erneut ohne Zusammenhang mit der Membran eines Ultraschallwandlers ist aus dem Artikel von C. Dietrich et al. "Wie wirksam ist der Laser?", adhäsion KLEBEN & DICHTEN, Vol. 58(6), Juni 2014, S. 36-39 bekannt, Edelstahl vor dem Kleben mit einem Laser vorzubehandeln. Dabei entstehen Mikrostrukturen, welche die Übertragung von Ultraschall beeinträchtigen würden.

Aus der EP 1 416 255 A1 ist ein Ultraschall-Transceiver mit einem piezoelektrischen Köroer und einer akustischen Anpassungsschicht bekannt, die aus einem Trockengel der Dicke I/4 besteht, also beispielsweise ca. 140µm bei 500 KHz. Die Oberfläche des piezoelektrischen Körpers kann mit einem Schmirgelpapier aufgeraut werden, um den Kontakt mit der Anpassungsschicht zu verbessern.

Die DE 10 2004 059 524 A1 offenbart ein Verfahren zur Herstellung eines Ultraschallwandlers, bei dem auf mindestens einer Oberfläche mittels Laserstrahlung eine wählbare Struktur aufgebracht wird. Die bearbeitete Oberfläche wird dann mit einer Beschichtung, beispielsweise einem Kleber, versehen, wobei die Struktur derart gewählt sein kann, dass die Haftung der Beschichtung unterstützt wird.

In der EP 2 602 596 A1 wird ein Ultraschall-Durchflussmesser mit einem oder mehreren Ultraschallwandlern beschrieben, deren Membran ein Edelstahlplättchen von einigen hundert Mikrometern Dicke sein kann.

In der Arbeit von Knapp, W., et al. "Influence of Structuring by Laser and Plasma Torch on the Adhesion of Metallic Films on Thermoplastic Substrates." Physics Procedia 56 (2014): 791-800 wird untersucht, welchen Einfluss eine Vorbereitung durch Laserstrukturieren auf die Adhäsion einer Aluminiumschicht und eines Thermoplasten hat, nämlich PP, PEEK oder PE.

Eine Ultraschallmessvorrichtung gemäß dem Oberbegriff des Anspruchs 1 ist aus der EP 0 945 712 A1 bekannt.

Daher ist Aufgabe der Erfindung, einen reproduzierbaren und beständigen Verbund zwischen Schwingkörper und Membran eines Ultraschallwandlers zu schaffen.

Diese Aufgabe wird durch eine Ultraschallmessvorrichtung zum Bestimmen einer Strömungsgeschwindigkeit nach Anspruch 1 b gelöst. Ein Schwingkörper, beispielsweise ein Piezoelement, regt durch entsprechende elektrische Ansteuerung eine Schwingung einer direkt mit dem Schwingkörper verbundenen Membran an, welche daraufhin Ultraschall abstrahlt. Umgekehrt wird empfangener Ultraschall registriert, indem der Schwingkörper von der Membran angeregt wird und ein der Schwingung entsprechendes elektrisches Signal erzeugt. Die Membran ist mit ihrer Innenfläche direkt mit dem Schwingkörper verbunden und strahlt an ihrer Außenfläche Ultraschall ab beziehungsweise empfängt ihn. Dabei geht die Erfindung von dem Grundgedanken aus, die Innenfläche mit einer Strukturierung zu versehen, um deren Oberfläche zu vergrößern. Dazu eignet sich bevorzugt eine Laserstrukturierung. Eine direkte Verbindung schließt natürlich nicht Mittel zum Schaffen dieser Verbindung aus, etwa eine Klebeschicht.

Die Erfindung hat den Vorteil, dass ein optimaler Haftverbund praktisch ohne akustische Verluste entsteht. Laserstrukturieren ist zudem ein definierter Prozess mit genau reproduzierbarem Ergebnis. Anders als etwa beim Sandstrahlen werden keine Fremdkörper eingeprägt, und es werden keine Werkzeuge verschleißt. Die Geometrie der Strukturierung ist frei wählbar und damit im Hinblick auf akustische Eigenschaften optimierbar.

Der Schwingkörper ist vorzugsweise mit der Innenfläche verklebt. Die Verbindung wird also sehr einfach durch Kleben hergestellt und profitiert besonders von der Oberflächenvergrößerung.

Die Membran ist bevorzugt aus Edelstahl hergestellt. Edelstahl ist gut schallleitend, unempfindlich gegen verschiedenste Substanzen der Fluide, leicht zu reinigen, mechanisch belastbar und druckfest.

Die Laserstrukturierung weist bevorzugt ein Dreiecksmuster auf. Dabei handelt es sich insbesondere um ein flächenfüllendes Gitter aus vorzugsweise gleichseitigen Dreiecken. Es hat sich herausgestellt, dass andere Muster, wie Quadratmuster, akustisch unvorteilhaft sind. Mit einem Dreiecksmuster verbessert sich die akustische Übertragung erheblich.

Die Laserstrukturierung weist bevorzugt ein Muster mit einem Rastermaß von einigen zehntel Millimetern auf. Das Muster weist demnach Kantenlängen von beispielsweise 0,1mm bis 0,8mm auf. Bei einem Dreiecksmuster mit Rastermaß 0,2mm und 0,6mm etwa werden keine akustischen Verluste festgestellt. Andere Strukturgrößen, insbesondere Mikrostrukturen, können sich dagegen als akustisch nachteilig erweisen.

In bevorzugter Weiterbildung ist eine Ultraschallmessvorrichtung zum Bestimmen der Strömungsgeschwindigkeit eines in einer Leitung strömenden Fluids mit einem in die Leitung einsetzbaren und auf diese Weise einen Abschnitt der Leitung bildenden Messkörper mit einem Strömungskanal für das Fluid und einer umgebenden Kanalwand vorgesehen, wobei mindestens ein erfindungsgemäßer Ultraschallwandler so an der Kanalwand angebracht ist, dass die Membran einen Teilbereich der Kanalwand bildet. Der Ultraschallwandler ist also in Clamp-In-Technik eingebaut, und die Membran hat direkten Kontakt zum Fluid. Oft wird die Ultraschallmessvorrichtung als Durchflussmesser genutzt, denn aus der Strömungsgeschwindigkeit lässt sich über die Leitungs- oder Kanalgeometrie, insbesondere den Leitungsquerschnitt, der Durchfluss bestimmen.

Vorzugsweise sind mindestens zwei einander bezüglich des Strömungskanalquerschnitts gegenüberliegende erfindungsgemäße Ultraschallwandler vorgesehen, die wechselweise als Sender und Empfänger arbeiten und zwischen einander einen Messpfad zur Bestimmung einer Laufzeitdifferenz für ein mit und gegen die Strömung des Fluids ausgesandtes Ultraschallsignal bilden. Diese Ultraschallmessvorrichtung arbeitet mit einem Laufzeitdifferenzverfahren, wobei zur Erhöhung der Messgenauigkeit insbesondere bei nicht homogener Strömung mehr als ein Messpfad mit weiteren erfindungsgemäßen Ultraschallwandlern denkbar ist.

Bei einem entsprechenden Herstellungsverfahren wird die Innenfläche der Membran vor der Verbindung mit dem Schwingkörper mit einer Strukturierung versehen, vorzugsweise einer Laserstrukturierung.

Vorzugsweise wird zunächst ein Edelstahlblech auf einer Fläche mit der Laserstrukturierung versehen, und anschließend werden eine oder mehrere Membrane aus dem Edelstahlblech ausgeschnitten. Die Membran entsteht also in zwei Schritten, wobei zunächst ein Rohling vorstrukturiert und dann die Membran aus dem Rohling herausgeschnitten wird. Beide Schritte können getrennt durch unterschiedliche Laser erfolgen, vorzugsweise wird jedoch derselbe Laser für das Herausschneiden genutzt und lediglich mit höherer Energie betrieben.

Die Membran wird dann vorzugsweise als Teilbereich einer Kanalwand in einen Strömungskanal einer Ultraschallmessvorrichtung eingeschweißt. Der Ultraschallwandler wird damit auf einfache Weise integraler Bestandteil einer Ultraschallmessvorrichtung in Clamp-In-Technik mit optimalem, akustisch so gut wie verlustfreiem und sehr beständigem Haftverbund zwischen Schwingkörper und der als Membran dienenden Kanalwand.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Schnittdarstellung der Verbindung eines Schwingkörpers und einer Membran eines Ultraschallwandlers;
- Fig. 2: eine Blockdarstellung des Ultraschallwandlers gemäß Figur 1;
- Fig. 3a: eine unbehandelte Innenfläche einer Membran nach dem Stand der Technik;
- Fig. 3b: eine laserstrukturierte Innenfläche einer Membran in einer Ausführungsform der Erfindung; und
- Fig. 4: eine Schnittdarstellung einer Ultraschallmessvorrichtung mit in Clamp-InTechnik eingebauten Ultraschallwandlern.

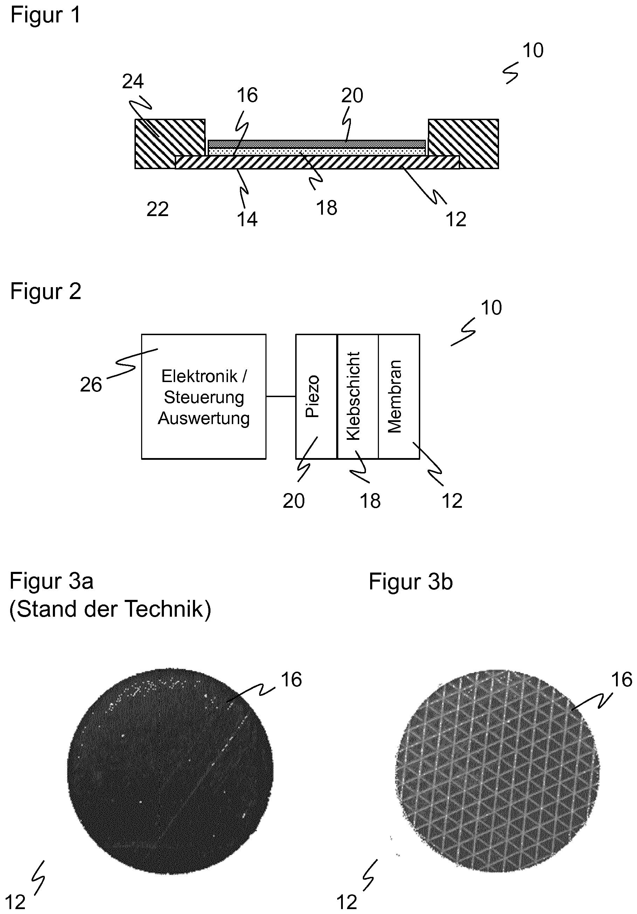

Figur 1 zeigt eine schematische Schnittdarstellung als Teilansicht eines Ultraschallwandlers 10. Der Ultraschallwandler 10 wird in Figur 2 ein weiteres Mal als Blockdarstellung illustriert. Eine schwingfähige Membran 12 weist eine Außenfläche 14 auf, an der Ultraschall abgestrahlt oder empfangen wird. Mit einer Innenfläche 16 ist die Membran 12 über eine Klebeschicht 18 mit einem Schwingkörper 20 verbunden. Die Membran 12 ist mittels einer umlaufenden Schweißnaht 22 in einer Aufnahme 24 befestigt.

Im Sendebetrieb wird der Schwingkörper 20, der häufig als Keramik bezeichnet wird und beispielsweise ein Piezoelement ist, mit Hilfe von an sich bekannter Elektronik 26 in Schwingung versetzt und regt so die verbundene Membran 12 zum Abstrahlen von Ultraschall an. Umgekehrt wird im Empfangsbetrieb die Membran 12 von empfangenem Ultraschall in Schwingung versetzt, und diese Schwingung erzeugt in dem verbundenen Schwingkörper 20 ein elektrisches Signal, das von der Elektronik 26 ausgewertet wird.

Um nun einen optimalen Klebeverbund zwischen Membran 12 und Schwingkörper 20 herzustellen, wird erfindungsgemäß die Oberfläche der Membran 12 durch Strukturieren der Innenfläche 16 mit einem Laserstrahl vergrößert. Figur 3a zeigt zunächst zum Vergleich eine Draufsicht auf die Innenfläche 16 der Membran 12 ohne Laserstruktur. Figur 3b zeigt eine entsprechende Draufsicht auf die Innenfläche 16 einer Membran 12, die mit einem Dreiecksmuster laserstrukturiert wurde. Das Dreiecksmuster hat sich als besonders vorteilhaft erwiesen, ist aber dennoch als Beispiel zu verstehen. Je nach Situation, etwa anregender Frequenz, sind auch andere Strukturen denkbar. Ebenso ist zwar die Strukturgröße in Figur 3b nicht angegeben und beispielhaft. Wählt man jedoch insbesondere ein Rastermaß im Bereich einiger zehntel Millimeter, so werden dadurch die akustischen Verluste bei der Übertragung von Ultraschall über die Verbindung mittels der Klebeschicht 18 minimiert. Bei einem Rastermaß von 0,2 mm und 0,6 mm wurden keine akustischen Verluste festgestellt.

In einer Ausführungsform wird zur Herstellung des Ultraschallwandlers 10 die Oberfläche eines Edelstahlblechs zunächst auf einer Fläche mit dem gewünschten Strukturierungsmuster von einem Laser vorstrukturiert und dann sogleich mit demselben Laser mindestens eine Membran 12 ausgeschnitten. Denkbar ist auch, diese Bearbeitung in zwei getrennten Schritten durchzuführen, wobei dann das strukturierte Edelstahlblech einen Zwischenstand bildet und die Außenkontur der Membran 12 in einem zweiten Arbeitsgang mit einem anderen Laser ausgeschnitten wird. Der Laserschnitt kann so gewählt werden, dass die Gratseite der strukturierten Seite gegenüber liegt, sich also an der Außenfläche 14 befindet.

Die entstandene, an ihrer Innenfläche 16 strukturierte Membran 12 wird dann etwa durch Laserschweißen in die Aufnahme 24 geschweißt, die vorzugsweise ebenfalls aus Edelstahl hergestellt ist. Die Gratseite liegt bei passend durchgeführtem Laserschnitt auf der Außenfläche 14, so dass die strukturierte Innenfläche 16 sauber in der Lagerung liegt und der Grat die umlaufende Laserschweißung unterstützen kann.

Die Aufnahme 24 mit der eingeschweißten Membran 12 kann nun noch oberflächenbehandelt werden, z. B. durch Beizen, um einen möglichen Verlust des Korrosionsschutzes durch die thermischen Einflüsse der Laserbehandlungen wieder auszugleichen. Das kann sowohl die Schweißnaht als auch die Strukturierung selbst betreffen. Gebeizte Oberflächen haben eine weitere Verbesserung des Haftverbundes der Klebung gezeigt.

Als Alternative zu einer Laserstrukturierung ist auch eine Prägung einer Struktur denkbar. Eine Laserstrukturierung ist aber vorteilhafter, denn durch Prägung wird eine lokale Verdichtung des Werkstoffs hervorgerufen, und es werden Spannungen eingeprägt. Dadurch kann das Schwingverhalten der Membran 12 beeinflusst werden. Außerdem ist die Geometrieauswahl beim Prägen werkzeugbedingt eingeschränkt, und das Werkzeug unterliegt dem Verschleiß.

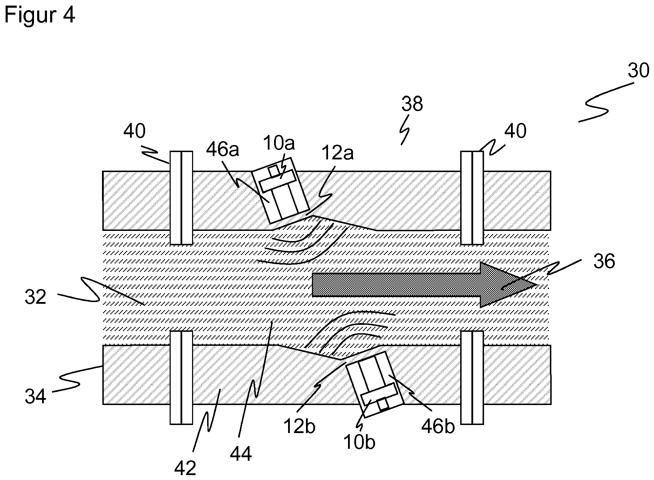

Figur 4 zeigt in einer vereinfachten Prinzipdarstellung eine Ultraschallmessvorrichtung 30 in Clamp-in-Technik zur Messung der Strömungsgeschwindigkeit beziehungsweise des daraus berechneten Durchflusses eines Fluids 32 in einer Rohrleitung 34, das in einer durch einen Pfeil 36 bezeichneten Richtung strömt. In der Ultraschallvorrichtung 30 sind ein oder mehrere erfindungsgemäße Ultraschallwandler montiert. Die Bestimmung der Strömungsgeschwindigkeit erfolgt beispielsweise mit dem einleitend genannten Differenzlaufzeitverfahren durch Auswertung der Laufzeiten bei Aussenden und Erfassen von Ultraschallsignalen zwischen einem Paar Ultraschallwandler 10a-b mit und gegen die Strömung in einer nicht dargestellten Steuer- und Auswertungseinheit. In anderen Ausführungsformen können ebenso nur ein Ultraschallwandler wie mehrere Ultraschallwandler vorgesehen sein.

Die Ultraschallmessvorrichtung 30 weist einen Messkörper 38 auf, der an Verbindungsstellen 40 in die Rohrleitung 34 eingefügt ist, beispielsweise durch Flanschverbindungen, und damit im montierten Zustand letztlich einen Teil der Rohrleitung 34 bildet. In einer Kanalwand 42 des Messkörpers 38, welche den eigentlichen Strömungskanal 44 umgibt, sind Ausbuchtungen oder Hohlräume 46a-b vorgesehen, in denen die Ultraschallwandler 10a-b montiert sind. Nach innen hin sind die Hohlräume 46a-b gerade durch die Membranen 12a-b abgeschlossen, die dort in die Kanalwand 42 eingeschweißt sind. So dient die Kanalwand 42 als die Aufnahme 24 und bildet nach dem Einschweißen der Membrane 12a-b eine in sich geschlossene Fläche ohne Vertiefungen oder Vorsprünge, an denen sich Ablagerungen absetzen könnten. Die von dem Fluid 32 abgewandten Innenflächen der Membrane 12a-b sind wie beschrieben strukturiert, und die in Figur 4 nicht als eigenes Bauteil gezeigten Schwingkörper der Ultraschallwandler 10a-b werden damit verklebt.

## Patentansprüche

1. Ultraschallmessvorrichtung (30) zum Bestimmen einer Strömungsgeschwindigkeit eines in einer Leitung (34) strömenden Fluids (32) mit einem in die Leitung (34) einsetzbaren und auf diese Weise einen Abschnitt der Leitung (34) bildenden Messkörper (38) mit einem Strömungskanal (44) für das Fluid (32) und einer umgebenden Kanalwand (42), wobei die Ultraschallmessvorrichtung (30) mindestens einen Ultraschallwandler (10) aufweist, der einen Schwingkörper (20) und eine Membran (12) mit einer Innenfläche (16) und einer Außenfläche (14) aufweist, wobei der Schwingkörper (20) direkt mit der Innenfläche (16) verklebt ist, und wobei der Ultraschallwandler (10) so an der Kanalwand (42) angebracht ist, dass die Membran (12) einen Teilbereich der Kanalwand (42) bildet,
**dadurch gekennzeichnet,**
**dass** die Innenfläche (16) eine Laserstrukturierung zur Oberflächenvergrößerung aufweist und dass die Laserstrukturierung ein Dreiecksmuster aufweist.

2. Ultraschallmessvorrichtung (30) nach Anspruch 1,
wobei die Membran (12) aus Edelstahl hergestellt ist.

3. Ultraschallmessvorrichtung (30) nach Anspruch 1 oder 2,
wobei die Laserstrukturierung ein Muster mit einem Rastermaß von einigen zehntel Millimetern aufweist.

4. Ultraschallmessvorrichtung (30) nach einem der vorhergehenden Ansprüche, die mindestens zwei gemäß Anspruch 1 ausgebildete, einander bezüglich des Strömungskanalquerschnitts gegenüberliegende Ultraschallwandler (10a-b) aufweist, die wechselweise als Sender und Empfänger arbeiten und zwischen einander einen Messpfad zur Bestimmung einer Laufzeitdifferenz für ein mit und gegen die Strömung des Fluids (32) ausgesandtes Ultraschallsignal bilden.

## Claims

1. An ultrasonic measuring apparatus (30) for determining a flow speed of a fluid (32) flowing in a line (34) having a measurement body (38) that can be placed into the line (34) and that in this manner forms a section of the line (34), having a flow passage (44) for the fluid (32) and having a surrounding passage wall (42), wherein the ultrasonic measuring apparatus (30) has at least one ultrasonic transducer (10) that has an oscillating body (20) and a membrane (12) having an inner surface (16) and an outer surface (14), with the oscillating body (20) being directly adhesively bonded to the inner surface (16), and wherein the ultrasonic transducer (10) is attached to the passage wall (42) such that the membrane (12) forms a part region of the passage wall (42),
**characterized in that**
the inner surface (16) has a laser structuring for increasing the surface; and **in that** the laser structuring has a triangular pattern.

2. An ultrasonic measuring apparatus (30) in accordance with claim 1,
wherein the membrane (12) is manufactured from stainless steel.

3. An ultrasonic measuring apparatus (30 in accordance with claim 1 or claim 2, wherein the laser structuring has a pattern having a grid dimension of some tenths of millimeters.

4. An ultrasonic measurement apparatus (30) in accordance with any one of the preceding claims that has at least two ultrasonic transducers (10a-b) that are configured in accordance with claim 1, that are disposed opposite one another with respect to the flow passage cross-section, that alternately work as a transmitter and as a receiver, and that form between them a measurement path for determining a transit time difference for an ultrasonic signal transmitted with and against the flow of the fluid (32).

## Revendications

1. Dispositif de mesure à ultrasons (30) pour déterminer une vitesse d'écoulement d'un fluide (32) qui s'écoule dans un conduit (34), comprenant un corps de mesure (38) susceptible d'être inséré dans le conduit (34) et de former de cette façon une tronçon du conduit (34) présentant un canal d'écoulement (44) pour le fluide (32) et une paroi de canal (42) périphérique, dans lequel le dispositif de mesure à ultrasons (30) comprend au moins un transducteur ultrasonique (10), qui comprend un corps vibratoire (20) et une membrane (12) avec une surface intérieure (16) et une surface extérieure (14), dans lequel le corps vibratoire (20) est collé directement sur la surface intérieure (16), et le transducteur ultrasonique (10) est rapporté sur la paroi du canal (42) de telle façon que la membrane (12) forme une région partielle de la paroi du canal (42),
**caractérisé en ce que**
la surface intérieure (16) présente une structuration formée par laser afin d'agrandir la surface, et **en ce que** la structuration formée par laser présente un motif triangulaire.

2. Dispositif de mesure à ultrasons (30) selon la revendication 1,
dans lequel la membrane (12) est réalisée en acier inoxydable.

3. Dispositif de mesure à ultrasons (30) selon la revendication 1 ou 2, dans lequel la structuration formée par laser présente un motif avec une trame d'une dimension de quelques dixièmes de millimètre.

4. Dispositif de mesure à ultrasons (30) selon l'une des revendications précédentes, qui comprend au moins deux transducteurs ultrasoniques (10a-b) réalisés selon la revendication 1, et mutuellement opposés par rapport à la section transversale du canal d'écoulement, qui fonctionnent alternativement comme émetteur et comme récepteur, et qui forment entre eux un trajet de mesure pour déterminer une différence de temps de parcours pour un signal ultrasonore émis avec et à l'encontre de l'écoulement du fluide (32).
